# EUROPEAN PATENT APPLICATION

(11) **EP 3 719 511 A1**
(43) Date of publication of application: **07.10.2020**
(21) Application number: 19166463.0
(22) Date of filing: 01.04.2019
(51) Int. Cl.: G01R 31/12, H02H 9/04, G01R 31/02

(54) **SENSOR AND METHOD FOR REMOTELY MONITORING THE STATE OF A SURGE ARRESTER**

(71) Applicant: Raycap Intellectual Property, Ltd., Nicosia (CY)
(72) Inventor: Vrabic, Gorazd, 1210 Ljubljana - Sentvid (SI); Zilic, Ivan, 1000 Ljubljana (SI); Brodnjak, Bostjan, 1358 Log pri Brezovici (SI)
(74) Representative: Flak, Antonija

(57) **Abstract**

The invention belongs to the field of devices for measuring electric variables, transmission systems for measured values as well as protection of arrangements for distribution of electricity. The invention relates to a sensor for monitoring the state of a surge arrester to which it is attached and to a monitoring method.

The sensor comprises:
- a housing for housing all sensor components, wherein temperature and humidity sensors are located on a housing exterior;
- power supply means for ensuring operational power;
- a part for connection to a power line having devices for measuring a capacitive and a resistive leakage current as well as a creepage current and devices for counting the number of surges,
- electronics for processing the measured parameters comprising:
o a processor for processing measured parameters, preferably a microprocessor,
o a connector to the temperature and humidity sensors,
o a connection to the power supply means,

- and a communication module for sending measured data to a remote location.

## Description

### Field of the invention

The present invention belongs to the field of measuring devices, more precisely to the field of devices for measuring electric and ambient variables. It is also related to the field of transmission systems for measured values as well as protection of arrangements for distribution of electricity. The invention relates to a sensor for monitoring the state of the surge arrester to which it is attached and to a method of monitoring the state of surge arresters.

### Background of the invention and the technical problem

Electric power distribution is the final stage in the delivery of electric power, in which electricity is carried from the transmission system to individual consumers through distribution substations. Electric power transmission and distribution of electrical energy along large distances is achieved by power lines. Power lines usually consist of one or more conductors (commonly multiples of three) suspended by towers or poles, while insulation is mostly provided by air. An important goal of power line design is to ensure adequate clearance between conductors and the ground in order to prevent dangerous contact with the line. Even more importantly, it is essential to provide reliable support for the conductors, resilience to storms, ice loads, earthquakes and other potential damage causes.

Power lines are tall structures; therefore they are often struck by lightning. A direct lightning strike on a power line conductor causes extremely high voltage pulses that propagate as traveling waves in either direction from the point of strike. Such events cause problems in the distribution network. To protect the equipment at the termination point of power lines, surge arresters are provided. These arresters channel overvoltage to the ground thus preventing its propagation into the substation equipment. This is possible as the energy of lightning transforms them into good conductors. Once the voltage decreases, the arresters return to their original high-impedance state.

The arresters are placed at different locations, for example on or near power lines, transformation stations, between power lines, etc.. Their distribution depends on the terrain, conditions at specific locations and occurrence of storms with lightning. Arrester is on one end connected to each phase of the line, while the other end is connected to the grounding system through short ground conductors.

Arresters always have a leakage current composed of two components, namely capacitive and resistive component. The leakage current depends on environmental humidity and temperature. At higher humidity the leakage is higher due to the capacitive component. Environmental temperature also affects the capacitive component. Higher leakage current indicates that the arrester is deteriorating and that its functioning is no longer optimal. Another indicator of deteriorated arrester is a high number of surges, especially when peak amplitudes of surges are high. Every surge causes a temperature increase of the arrester.

It is therefore an aim of the invention to provide a sensor for surge arresters to monitor their state and signal whether the arrester has deteriorated and consequently has to be replaced. The technical problem is thus to design a sensor to be installed near surge arresters, which is able to monitor the status (health) of the arrester and transfer the measured data to control system so that readings can be done remotely offering easier asset management.

Conventional surge arrester monitors display only the number of surges discharged by one specific surge arrester and some of them also the instantaneous leakage current through it. This data is displayed locally, at the surge arrester, inside the substation. Such data give only a vague picture of the surge arrester's condition. Additionally, some surge arrester monitors provide information on resistive leakage current, which is often influenced my electromagnetic fields of nearby transmission lines and technically expensive to realize. Such solution has been found as very unreliable providing data for surge arrester health assessment. There is a need, however, to obtain more reliable information about state of arresters in order to maintain optimal electrical energy distribution.

### State of the art

Known devices for monitoring arresters mostly measure only the resistive component, while only few devices such as monitors disclosed in documents CN207817047, DE102015013433 and JPH112652 measure total leakage current. More precisely the utility model CN207817047 discloses an online monitoring device, comprising housing, screen, alarm and lightning parameter sensor sensing the total current composed of resistive and capacitive electric current and the number of lightning strikes.

Patent DE102015013433 describes a monitoring device for a surge arrester with a means for detecting a total leakage current flowing between the surge arrester and ground, a field sensor for detecting an electric field in the vicinity of the surge arrester, and a communication unit for contactless transmission of data to an external device, wherein the communication unit is a near-field communication unit for contactless data exchange by means of near-field communication (NFC).

Utility model JPH112652 discloses an instrument for measuring leakage current of arrester which can reliably and easily detect all leakage currents, wherein the resistance component is calculated. The instrument has an electric field sensor provided near or on the frame of an arrester, which detects a system voltage and Fourier transforming sections find the higher harmonic component and phase at each order by respectively performing Fourier transformation on the detected waveforms of a leakage current and a voltage. Then waveform approximating sections find the approximate waveforms of both detected waveforms and a differential arithmetic section finds an approximate waveform for cancellation by differentiating the approximate waveforms. Thereafter, a phase adjusting section matches the phases of both approximate waveforms to each other and a level adjusting section matches the levels of the fundamental wave components of both approximate waveforms to each other. Finally, a differential arithmetic section finds a resistance-component current by subtracting the approximate waveform for cancellation from the approximate waveform of the leakage current.

However, these solutions are limited as they do not provide all information needed to reliably determine arrester's state. Devices according to the mentioned documents need to be read on a monitor or with near-field-communication (NFC) means, which is not desired. The present invention differs in that more parameters are measured and that readings are performed remotely.

Devices known from documents CN206178063, CN206470350 and CN208140817 are adapted to measure ambient temperature and/or humidity in addition to resistive leakage current.

Utility model CN206178063 discloses a real-time on-line monitoring device for an arrester. The monitoring device comprises a single chip, clock circuit, lithium cell, leakage current mutual-inductor, signal pre-processing module, alarm unit, analogue-to-digital conversion module as well as temperature and humidity sensor.

Utility model CN206470350 describes a monitoring system that comprises a leakage current sensor, a leakage current modulate circuit and information sensing device, wherein the latter comprises a temperature sensor and a humidity sensor. Measured parameters are sent to a microprocessor unit and subsequently to a remote monitoring centre.

Utility model CN208140817 discloses a lightning arrester on-line monitoring system which has an environmental parameter sensor, current sensor with the ground loop, the signal transmission circuit to transmit environmental parameter signals and leakage current signals to a controller. The latter checks whether the measured signals correspond to pre-set values and in case of an increased leakage current triggers an alarm.

These solutions provide more information to management centres; however they are less reliable than the present invention. The latter namely provides a more complex monitoring method surge arrester performance which improves efficiency of analysis and management.

### Description of the solution of the technical problem

The sensor for monitoring the state of surge arresters according to the invention measures several different parameters, which are closely intertwined in the assessment of surge arrester performance. The sensor measures:
- total leakage current composed of two components:
   ∘ the capacitive and resistive current flowing through the arrester, and
   ∘ the creepage current flowing on the arrester surface,
- environmental temperature,
- environmental humidity,
- the number of surges, and
- peak amplitude of surges.

Measured values are processed by a processor and sent by a communication module in a wireless or an optical manner to a remote location, where they can be read. Based on readings maintenance crew can reliably establish whether the surge arrester should be replaced or not.

The essence of the sensor according to the invention is that it comprises:
- housing for housing all components, wherein the temperature and humidity sensor are located on an outer surface of the housing;
- power supply means for ensuring adequate power for the sensor to operate, preferably the power supply means are a battery and/or photovoltaic cells, the latter being installed on the outer surface of the housing;
- a part for connection to a surge arrester on one side and ground on other side having devices for measuring total leakage current and counting the number of surges,
- electronics for processing the measured parameters, which are divided from the connection to a surge arrester, wherein the electronics comprise:
   ∘ a processor programmed for processing measured parameters, preferably a microprocessor,
   ∘ a connector to the temperature and humidity sensors,
   ∘ a connection to power supply means, and
- a communication module for sending measured data to a remote location.

The sensor sends periodically heart-beat signal so the management system and user can identify whether the system is still functional or not.

Total leakage current is measured by a current sensor, surges are measured by toroid coil, while temperature and humidity are preferably measured by a digital temperature sensor and a digital humidity sensor, respectively. Leakage current and surge recognition could also be performed by any other known device; however the above mentioned choices are preferred as they show highest immunity to surges. The sensor preferably has two circuits, namely:
- an analogue measurement circuit for fast events, for example surges;
- a microprocessor based main circuit:
   ∘ for measurement of leakage-current, temperature and humidity, and
   ∘ for control, data storage and communication.

The sensor preferably has two operating modes:
- a normal operating mode, in which parameters are sampled once per hour and an averages of measurements determined by the microprocessor are reported as a daily average; and
- a high-resolution mode, in which parameters are determined once per minute and averages of measurements determined by the microprocessor are reported hourly.

It would also be possible for the sensor to have only one operation mode, either the normal or the high resolution. The latter would consume more energy and would provide extensive, probably unnecessary data, while the first may provide too little information at the time of actual surges. Therefore the two-mode operation is preferred. The change between two modes of operation is triggered by detection of a surge. In case of a surge discharged through the arrester, the sensor switches to the high resolution mode, the peak-value is recorded in real-time and transmitted instantly to provide the possibility for condition monitoring and proactive maintenance. After a pre-determined time, for example one hour, the high resolution mode is preferably automatically switched to the normal operating mode if there were no further surges. In absence of surges the sensor operates in the normal mode.

All measured data are sent to the microprocessor, which is suitably programmed to process the data, i.e. averaging with regards to the time frame depending on the mode of operation, filtering, etc., and sends to user through communication interface, which may be wireless or optical.

The communication module is preferably based on a long-range LoRaWAN protocol, wherein the sensor has a LoRa antenna/transmitter located on the housing, through which the data are in a wireless manner sent to a LoRa gateway. The latter is via LAN or GSM connected to a cloud. A user can connect to the cloud with a computer in order to read the measured parameters. Although wireless sending of measurements can be achieved by any communication protocol, LoRa is preferred because it has a long range and low energy consumption. The usual range is around 10 km, while the maximum range may also be 70 km.

All data are preferably displayed on a web-based service or a server or a cloud to be accessed from a computer. The preferred data shown are:
- discharge current: last value, Date/Time of event;
- temperature: 24 hr average & trend, Date/Time;
- humidity: 24 hr average & trend, Date/Time;
- leakage current: 24 hr average & trend, Date/Time;
- listings and tables of individual data.

The leakage current of a surge arrester at nominal system voltage is typically between 50 µA und 1 mA. An increase in voltage over time indicated a deteriorated arrester. The creepage current depends on weather conditions, humidity and surface pollution. It can vary between 0 and multiples of 10 mA. If the total leakage is high, it can be a result of:
- a high number of surges;
- high environmental humidity, which increases the capacitive component of the leakage current,
- high ambient temperature, or
- indicates a deteriorated state of the surge arrester.

In order to determine the health of the surge arrester one has to check the number of surges, the leakage current and correlate this data to humidity and temperature. In general, high leakage current indicates deteriorated surge arrester if ambient conditions are normal (low humidity and not extremely high temperature), since high total leakage current may be a result of ambient conditions and not deteriorated surge arrester. The second indication that surge arresters may be near the end of life is high number of surges of a high peak amplitude. In addition, total leakage current readings can indicate the status of the transmission line to which the product is connected through the surge arrester. Zero leakage current can indicate that the transmission line is not connected to sensor or it is earthed, while greater than zero indicates that transmission line is charged.

The state or performance of surge arresters is monitored with a monitoring method comprising the following steps:
a) determining the total leakage current:
   i. measuring the total leakage current by the current sensor;
   ii. amplifying the signal and processing by alternate current (AC) to true root mean square (TRMS) converter;
   iii. sending the value to the microprocessor;
b) determining the number of surges:
   i. Surges are measured by the toroid coil;
   ii. Integrating and amplifying the signal; and
   iii. Sending the signal through an analogue to digital (ADC) converter to the microprocessor;
c) determining the ambient temperature by the digital temperature sensor and sending the data to the microprocessor;
d) determining the ambient humidity by the digital humidity sensor and sending the data to the microprocessor;
e) processing of data such as averaging and filtering;
f) sending the parameters via the communication module for analysis;
g) determining the state of the surge arrester based on the measured parameters in steps a) to d).

The method is performed by the sensor device according to the invention and is repeated periodically depending on the mode of operation of the sensor.

The present invention can be installed on the ground lead of any surge arrester. There is no need for any power supply or additional wiring. The sensor is intended to monitor the state of high- and medium-voltage arresters.

The sensor according to the invention provides continuous diagnosis of the equipment in service, record-keeping of historical data of performance parameters, trend analysis of events, and suggesting necessary corrective action to keep the equipment working effectively. This cuts maintenance costs and reduces unplanned outages.

The sensor for monitoring the state of surge arresters according to the invention will be further detail based on embodiments and figures, which show:
- Figure 1: Embodiment of the sensor
- Figure 2: Embodiment of the sensor interior
- Figure 2a: Schematic representation of the essential steps of the monitoring method
- Figure 3: Possible installation of the sensor
- Figure 4: Data transmission over LoRaWAN

In the scope of the invention as described herein and defined in the claims, other embodiments of the sensor for monitoring the state of surge arresters obvious to a skilled person are possible, but this does not limit the essence of the invention as described herein on the basis of embodiments.

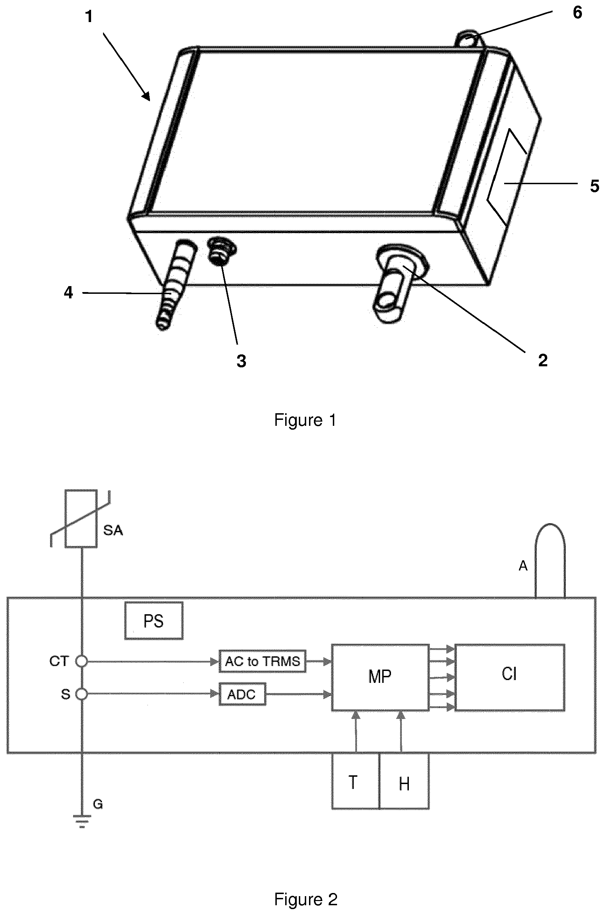

Figure 1 shows a possible embodiment of the sensor 1 for monitoring the state of surge arresters comprising:
- a connection 2 to a station ground;
- a temperature and humidity sensor 3;
- an antenna 4;
- solar panels 5; and
- connection to the arrester ground 6.

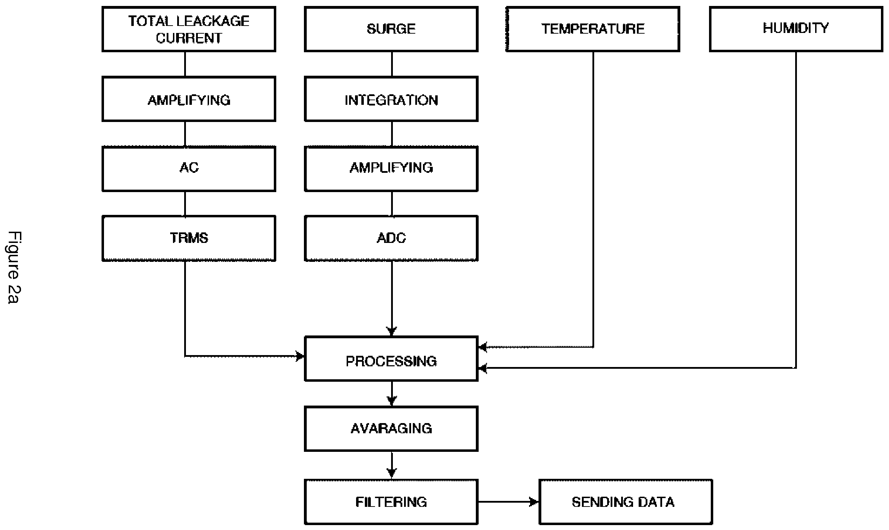

Figures 2 and 2a show a possible interior and essential functioning steps of the monitoring method performed by the sensor, showing connection to the surge arrester SA and ground G. The total leakage current is measured by a current sensor CT, while surges are measured by a toroid coil S, while temperature and humidity are preferably measured by a digital temperature sensor and a digital humidity sensor. Power source PS is provided for powering the sensor.

After measuring the total leakage current by the current sensor CT the signal is amplified and processed by an AC to TRMS converter. Signals from the toroid coil S are integrated and amplified and finally sent through an ADC converter to the microprocessor MP. Signals from the current sensor CT and the toroid coil S are sent to the microprocessor MP together with data from temperature sensor T and humidity sensor H, which are integrally formed. Data are sent via the communication interface CI and the antenna A.

During the normal operation mode of the sensor, the microprocessor based main circuit is in a standby mode and therefore requires only a minimal amount of battery power. This main circuit wakes up every hour, measures leakage-current, temperature and humidity. The data are stored in the main memory and the circuit goes back to standby. All 24 hours main circuit calculates average values from the stored measurements and transmits them to the main data server. Each transmission should be acknowledged by the server, otherwise transmission will be repeated until acknowledgment. In the event of a surge (lightning or switching), the data (discharge currents) will be measured by the analogue circuit and stored in a temporary memory. The microprocessor based main circuit will be triggered to wake up, transfer the data from the temporary to the main storage and transmit the event and data to the main server. Again the server should acknowledge data reception.

The threshold for surges is pre-determined, preferably at 100 A. The sensor has an event-time recording range from 100 A to 100 kA, all identified events are transmitted instantly. Leakage current measurement is preferably displayed as an average value in 24 hr and usually ranges from 50 µA to 10 mA. Ambient temperature and humidity are shown as average values in 24 hr. Range for sensing the temperature is preferably from -40 to + 85 °C and for humidity from 0 to 100%.

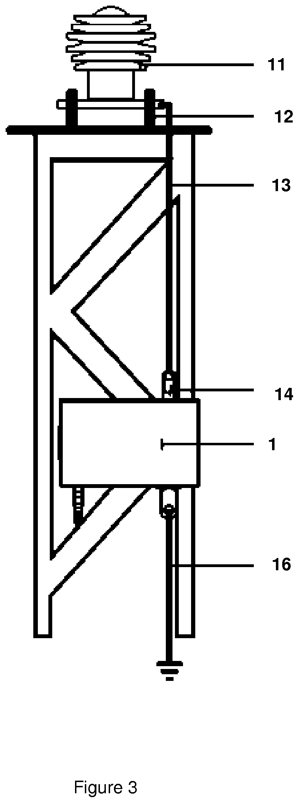

Figure 3 shows a possible installation of the sensor according to the invention, wherein the surge arrester 11 is placed on an isolated support 12. An isolated ground lead 13 from the surge arrester 11 to the sensor 1 having a top terminal 14 for connection with the surge arrester and a ground lead 16 for grounding the sensor 1 and the surge arrester 11. The sensor according to the invention can be attached to the framework of a power line or a transformer station.

In a preferred embodiment the communication module is based on LoRa. LoRaWAN uses the unlicensed radio spectrum. Data are transmitted according to LoRaWAN specifications. The transmission protocol is encrypted from the sensor to the server with an AES-128 key. Each sensor is identified in the network with its individual MAC address and directly connected to the server. LoRaWAN to Ethernet and LoRaWAN to GSM Gateways are commercially available for connection where coverage is not available.

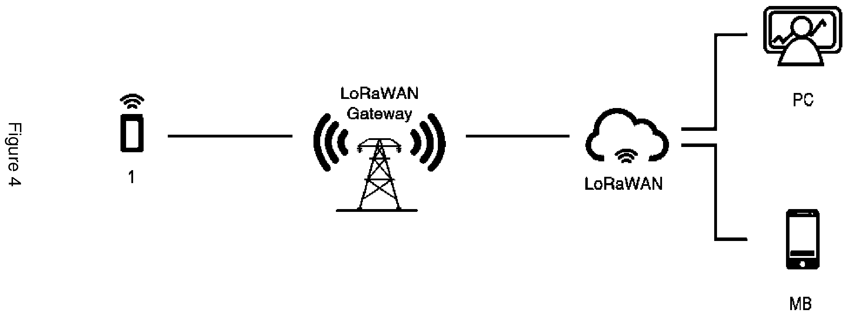

Figure 4 shows system architecture of the transmission network from sensors to management system. Sensors 1 connected to transmission lines and/or substations are transmitting acquired data over LoRaWAN network to LoRaWAN gateways, which should be places within LoRaWAN access range. LoRaWAN gateways are usually installed on a high tower which ensures larger range. Data are then sent over LAN or GSM network to LoRaWAN operator infrastructure redirecting data to determined cloud management system. Data can be then accessible on personal computers PC, usually located in offices or control centres or on mobile devices MB.

## Claims

1. A sensor for monitoring the state of surge arresters comprising:
- housing for housing all components, wherein a temperature and humidity sensor is located on an outer surface of the housing;
- power supply means for ensuring adequate power for the sensor to operate;
- a part for connection to a surge arrester on one side and ground on other side having devices for:
∘ counting the number of surges,
∘ peak amplitude of surges, and
∘ measuring total leakage current comprised of:
▪ the capacitive and resistive current flowing through the arrester, and
▪ the creepage current flowing on the arrester surface,
- electronics for processing the measured parameters, which are divided from the connection to the surge arrester, wherein the electronics comprise:
∘ a processor programmed for processing measured parameters, preferably a microprocessor,
∘ a connector to the temperature and humidity sensor,
∘ a connection to power supply means, and
- a communication module for sending measured data to a remote location.

2. The sensor for monitoring the state of surge arresters according to claim 1, **characterized in that** the total leakage current is measured by a current sensor, surges are measured by a toroid coil, while temperature and humidity are preferably measured by a digital temperature sensor and a digital humidity sensor.

3. The sensor for monitoring the state of surge arresters according to claim 2, **characterized in that** the sensor is arranged to amplify the measured total leakage current signal and process it by alternate current (AC) to true root mean square (TRMS) converter; and **in that** the sensor is arranged to integrate and amplify the signal from the toroid coil.

4. The sensor for monitoring the state of surge arresters according to any of the preceding claims, **characterized in that** microprocessor is arranged to process the measured parameters, namely total leakage current, number of surges, amplitude of surges, temperature and humidity.

5. The sensor for monitoring the state of surge arresters according to any of the preceding claims, **characterized in that** the microprocessor is arranged to perform averaging and/or filtering of measured parameters with regards to a pre-defined time frame depending on the sensor's mode of operation.

6. The sensor for monitoring the state of surge arresters according to any of the preceding claims, **characterized in that** it has pre-defined thresholds for surges, preferably at 100 A, wherein the recording range is from 100 A to 100 kA.

7. The sensor for monitoring the state of surge arresters according to any of the preceding claims, **characterized in that** communication interface is wireless or optical.

8. The sensor for monitoring the state of surge arresters according to the previous claim, **characterized in that** the communication module is based on a long-range LoRaWAN protocol, wherein the sensor has a LoRa antenna/transmitter located on the housing, through which the data are in a wireless manner sent to a LoRa gateway, the latter being connected via LAN or GSM to a cloud to which a user can connect in order to read the measured parameters.

9. The sensor for monitoring the state of surge arresters according to any of the preceding claims, **characterized in that** preferably the power supply means are a battery and/or photovoltaic cells, the latter being installed on the outer surface of the housing.

10. The sensor for monitoring the state of surge arresters according to any of the preceding claims, **characterized in that** it has two circuits, namely:
- an analogue measurement circuit for fast events, for example surges;
- a microprocessor based main circuit:
∘ for measurement of leakage-current, temperature and humidity, and
∘ for control, data storage and communication.

11. The sensor for monitoring the state of surge arresters according to any of the preceding claims, **characterized in that** it has two operating modes:
- a normal operating mode, in which parameters are sampled once per hour and an averages of measurements determined by the microprocessor are reported as a daily average; and
- a high resolution mode, in which parameters are determined once per minute and an averages of measurements determined by the microprocessor are reported hourly.

12. The sensor for monitoring the state of surge arresters according to any of the preceding claims, **characterized in that** the health of the surge arrester is determined based on the number of surges, the leakage current and correlation of both to humidity and temperature, wherein high leakage current in normal ambient conditions of low humidity and not extremely high temperature indicates deteriorated surge arrester or a high number of surges of a high peak amplitude are indicative of deteriorated surge arrester; and/or **in that** zero leakage current indicates that the transmission line is not connected to the sensor or it is earthed, while leakage current values greater than zero indicate that transmission line is charged.

13. Use of the sensor for monitoring the state of surge arresters according to any of the preceding claims in monitoring the state of high- and medium-voltage arresters.

14. A method for monitoring the state or performance of surge arresters with the sensor according to any claim from 1 to 12, the method comprising the following steps:
a) determining the total leakage current:
i. measuring the total leakage current by the current sensor;
ii. amplifying the signal and processing by alternate current (AC) to true root mean square (TRMS) converter;
iii. sending the value to the microprocessor;
b) determining the number of surges:
i. surges are measured by the toroid coil;
ii. integrating and amplifying the signal; and
iii. sending the signal through an analogue to digital (ADC) converter to the microprocessor;
c) determining the ambient temperature by the digital temperature sensor and sending the data to the microprocessor;
d) determining the ambient humidity by the digital humidity sensor and sending the data to the microprocessor;
e) processing of data such as averaging and filtering;
f) sending the parameters via the communication module for analysis;
g) determining the state of the surge arrester based on the measured parameters in steps a) to d),
wherein the method is repeated periodically depending on the mode of operation of the sensor.

15. The method according to claim 14, **characterized in that** during normal operation mode the microprocessor based main circuit is operating in a standby mode and the main circuit measuring all parameters in hourly manner and storing the measurements in the main memory, thereafter the circuit going back to standby, wherein after 24 hours the main circuit calculates average values from the stored measurements and transmits them to the main data server; and **in that** in the event of a surge the analogue circuit performs measurements instantly storing them in a temporary memory, followed by triggering of the microprocessor based main circuit to transfer the data from the temporary to the main storage and transmit the event and data to the main server.
